Europäisches Patentamt

European Patent Office

Office européen des brevets

(19)

(11) **EP 1 531 490 A1**

(12) **EUROPEAN PATENT APPLICATION**
published in accordance with Art. 158(3) EPC

(43) Date of publication:
**18.05.2005 Bulletin 2005/20**

(21) Application number: **03747203.2**

(22) Date of filing: **28.03.2003**

(51) Int Cl.⁷: **H01L 21/205**

(86) International application number:
**PCT/JP2003/004016**

(87) International publication number:
**WO 2003/092059 (06.11.2003 Gazette 2003/45)**

(84) Designated Contracting States:
**AT BE BG CH CY CZ DE DK EE ES FI FR GB GR
HU IE IT LI LU MC NL PT RO SE SI SK TR**

(30) Priority: **24.04.2002 JP 2002122240**

(71) Applicant: **Japan Science and Technology
Agency
Kawaguchi-shi, Saitama 332-0012 (JP)**

(72) Inventor: **Yasaka, Mitsuo,
Kyushu Works, Tokyo Cathode
Aso-gun, Kumamoto 861-2401 (JP)**

(74) Representative: **Viering, Hans-Martin, Dipl.-Ing.
Patent- und Rechtsanwälte
Viering, Jentschura & Partner,
Steindorfstrasse 6
80538 München (DE)**

(54) **WINDOW TYPE PROBE, PLASMA MONITORING DEVICE, AND PLASMA PROCESSING DEVICE**

(57)     This invention relates to a detection port type probe, a plasma monitoring device, and a plasma processing apparatus. It is intended to directly and conveniently detect a state of plasma generated by an application of a radio frequency or a high voltage, and the detection port type probe is provided with at least an electroconductive supporting member (5) having an opening formed on at least a part of a surface thereof facing to plasma and a dielectric member (1) having a probe electrode (2) formed on one side thereof positioned at the opening of the electroconductive supporting member (5).

FIG. 1

EP 1 531 490 A1

## Description

Technical Field

The present invention relates to a detection port type probe, a plasma monitoring device, and a plasma processing apparatus and, particularly, to those characterized by a constitution for easily, efficiently, and accurately detecting a fluctuation in plasma in a plasma processing apparatus which performs processing on a substrate using plasma discharge caused by a radio frequency or a high voltage.

Background Art

At present, a plasma processing method for processing a substrate by using plasma discharge is widely used for the purpose of plasma CVD, ashing, etching, sputtering, or a surface treatment in the field of semiconductor manufacture.

In plasma processing steps of the plasma treatment, a variation in characteristics of electric elements provided on the substrate to be processed is undesirably caused due to insufficiency in stability and reproducibility of generated plasma in the case of applying a high voltage or a radio frequency voltage from a radio frequency power source.

In order to solve the above problem, there is a demand for accurately detecting determinations of the reproducibility and the stability of the plasma.

At present, various studies are conducted so as to meet such demand, and a fluctuation in plasma is detected through a detection of changes in plasma emission intensity, changes in voltage and current of a power source, changes in plasma impedance, or changes in higher harmonic wave in the case of anomalous discharge and through detections of a fluctuation in gas pressure and changes in emission spectrum in the case of the determinations of the reproducibility and the stability of plasma, i.e. determination of the fluctuation in plasma.

Further, in order to monitor the changes in voltage or current from the RF power source or the changes in plasma impedance, a detector is inserted in a power line.

However, the above-described known methods involve drawbacks relating to influences on plasma characteristics, efficiency, and convenience and raises problems of increased cost and necessity for extra space for installing the components.

Therefore, an object of this invention is to directly and conveniently detect a state of plasma generated by an application of a radio frequency or a high voltage.

Disclosure of the Invention

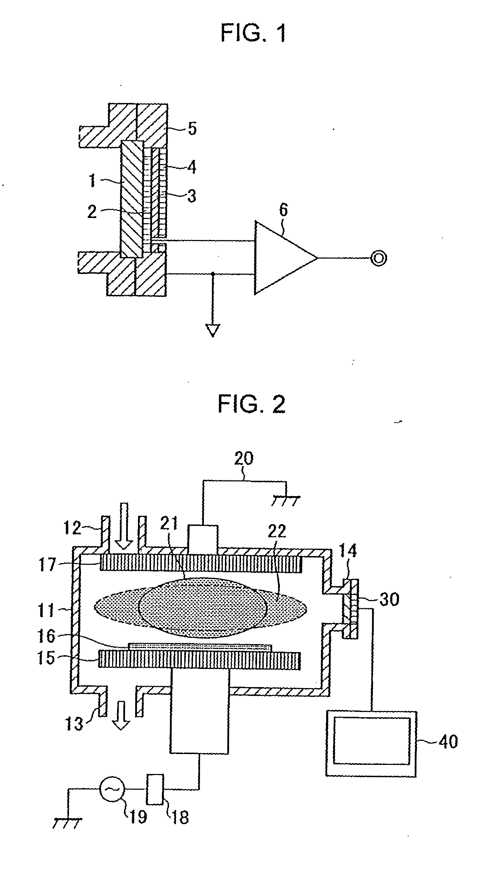

Fig. 1 is a theoretical block diagram of this invention, and means for solving the problems according to this invention will be described with reference to Fig. 1.

Reference is made to Fig. 1.

(1) This invention is characterized in that a detection port type probe comprises at least an electroconductive supporting member 5 having an opening formed on at least a part of a surface thereof facing to plasma and a dielectric member 1 having a probe electrode 2 formed on one side thereof positioned at the opening of the electroconductive supporting member 5.

Since such detection port type probe is simply mounted on a side wall of a process chamber, it is unnecessary to insert the probe into the process chamber for its installation; therefore, the detection port type probe will not influence on a state of the plasma and enables monitoring of the plasma state with the simple constitution.

More specifically, since a potential called wall potential is induced on a surface of the dielectric member 1 facing to the plasma due to the plasma generated inside the process chamber, it is possible to monitor the plasma state through a monitoring of a fluctuation in wall potential. In order to stabilize the detected potential, it is preferable to shield the probe electrode 2 with an electromagnetic shielding member 4 via an insulating member 3.

(2) Also, this invention according to item (1) is characterized by connecting an impedance matching unit 6 to the probe electrode 2.

In order to detect the voltage from the probe electrode 2, it is necessary to connect the impedance matching unit 6 such as an amplifier, an impedance converter, and a resistance between the probe electrode 2 and a voltage measurement system.

(3) Also, this invention is characterized in that the dielectric member 1 defined in item (1) or (2) is made from an optically transparent glass.

The dielectric member 1 on which the wall potential is induced may not be transparent, but it is preferable to use an optically transparent glass for the dielectric member to make it possible to optically observe reactions and the like inside the process chamber.

(4) Also, this invention is characterized in that the probe electrode 2 defined in item (3) is made from an optically transparent electroconductive substance.

In the case where an area of the probe electrode 2 is increased so as to enhance a wall potential detection sensitivity, it is necessary to form the probe electrode 2 from the optically transparent electroconductive substance for the purpose of optically observing reactions and the like occurring in the process chamber by way of the detection port type probe.

(5) Also, this invention is characterized in that the opening defined in any one of items (1) to (4) formed on the electroconductive supporting member 5 has a function of a viewing port.

Thus, owing to the viewing port function, it is possible to use the opening also as a viewing port disposed in the process chamber, thereby simplifying an apparatus constitution.

(6) Also, this invention is characterized in that a plasma monitoring device uses the detection port type probe defined in any one of items (1) to (5) and comprises a voltage waveform measuring unit for measuring voltage waveform, the voltage waveform measuring unit being disposed at an output end of the detection port type probe.

In the case of constituting the plasma monitoring device using the detection port type probe, the voltage waveform measuring unit for measuring voltage waveforms is disposed at the output end of the detection port type probe, thereby monitoring the plasma state using the voltage waveforms.

The voltage waveform measuring unit is provided at least with an A/D converter for analog/digital converting voltage waveforms and a data processing unit for monitoring the plasma state by deriving an average waveform, an average voltage, an average amplitude, and the like by processing the voltage waveforms.

(7) Also, this invention according to item (6) is characterized by comprising a process monitoring mechanism for detecting a stability of plasma by detecting a degree of nonuniformity among cyclical waveform changes of the voltage waveform detected by the voltage waveform measuring unit.

Thus, by detecting the nonuniformity among cyclical waveform changes of the voltage waveforms, it is possible to accurately monitor the plasma state during the plasma processing.

(8) Also, this invention according to item (6) is characterized by comprising an anomalous discharge monitoring mechanism for detecting plasma anomalous discharge from the change in voltage waveform detected by the voltage waveform measuring unit.

Thus, by detecting plasma anomalous discharge from the change in voltage waveform detected by the voltage waveform measuring unit, it is possible to monitor an anomalous discharge occurs suddenly during the plasma processing.

(9) Also, a plasma processing apparatus of this invention is characterized by comprising the plasma monitoring device defined in any one of items (6) to (8).

It is possible to perform plasma processing with higher reproducibility by providing the plasma processing apparatus with the plasma monitoring device.

(10) Also, this invention according to item (9) is characterized in that the electroconductive supporting member 5 provided with the opening is a flange constituting a viewing port of a reaction vessel and that the dielectric member 1 is a transparent glass plate for sealing the flange.

Since it is possible to use the viewing port, i.e. the flange constituting the viewing port, for mounting the plasma monitoring device on an existing plasma processing apparatus, the necessity for extra space for the probe is eliminated, thereby simplifying the apparatus constitution.

Brief Description of the Drawings

Fig. 1 is an illustration of a theoretical constitution of this invention.
Fig. 2 is a schematic block diagram showing a plasma processing apparatus with a detection port type probe according to a first embodiment of this invention.
Fig. 3 is a schematic block diagram showing the detection port type probe used in the first embodiment of this invention.
Fig. 4 is an illustration of waveforms detected by the detection port type probe in RF discharge.
Fig. 5 is an illustration of a waveform detected by the detection port type probe when an input power fluctuates in RF discharge.
Fig. 6 is an illustration of a waveform detected by the detection port type probe when an RF power source is immediately disconnected after apparatus malfunction in RF discharge.
Fig. 7 is an illustration of a method of processing the waveform detected by the detection port type probe in the first embodiment of this invention.
Fig. 8 is a schematic block diagram showing a plasma processing apparatus with an anomalous discharge monitoring device according to a second embodiment of this invention.
Fig. 9 is an illustration of a waveform detected by a detection port type probe in DC discharge in the second embodiment of this invention.
Fig. 10 is an illustration of a waveform detected by the detection port type probe in RF discharge in the second embodiment of this invention.
Fig. 11 is a schematic block diagram showing a plasma processing apparatus with an anomalous discharge monitoring device according to a third embodiment of this invention.
Fig. 12 is an illustration of an anomalous discharge detection method in the third embodiment of this invention.
Fig. 13 is a schematic block diagram showing a detection port type probe according to a fourth embodiment of this invention.

Best Mode for Carrying out the Invention

Hereinafter, a plasma processing apparatus with a detection port type probe and a detection signal processing method according to a first embodiment of this invention will be described with reference to Figs. 2 to 7.

Reference is made to Fig. 2.

Fig. 2 is a schematic block diagram showing the plasma processing apparatus with the detection port type probe according to the first embodiment of this invention.

This plasma processing apparatus is constituted of a process chamber 11 having a gas inlet 12, an outlet 13, and a probe mounting portion 14, a parallel flat plate type electrode disposed inside the process chamber and having a lower electrode 15 on which a Si wafer 16 is placed and an upper electrode 17 used also as a shower head for injecting an introduced gas and opposed to the lower electrode 15, a radio frequency power source 19 for applying an RF power of 13.56 MHz via a matching unit 18 constituted of a blocking condenser or the like and performing an impedance matching with the lower electrode 15, and an earthed wiring 20 for earthing the upper electrode 17.

The probe mounting portion 14 is formed of a flange member used for constituting ordinary viewing ports, and a detection port type probe 30 is attached to the flange member so that a detection output from the detection port type probe 30 is connected to a digital oscilloscope 40 via a coaxial cable.

An input impedance of the digital oscilloscope 40 is 50 ohms for example.

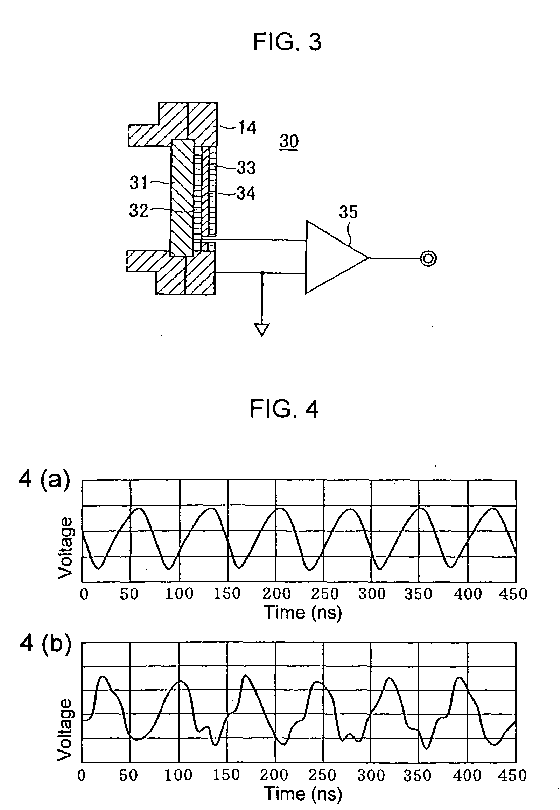

Reference is made to Fig. 3.

Fig. 3 is a schematic block diagram showing the detection port type probe according to the first embodiment of this invention, and the detection port type probe 30 is constituted of a glass plate 31 made from an optically transparent glass used for ordinary viewing ports, such as a kovar glass, a probe electrode 32 disposed on outer surface of the glass plate 31 with respect to plasma and formed from ITO or the like, a transparent insulating film 33 made from polyester or the like and insulating-coating a surface of the probe electrode 32, an ITO shield 34 for electromagnetically shielding the probe electrode 32 disposed on the transparent insulating film 33, and an impedance converter 35.

In this case, the probe electrode 32 has no periphery so as to avoid electrical short with the probe mounting potion 14, and a small opening is formed on each of the ITO shield 34 and the transparent insulating film 33 so that the probe electrode 32 is connected to the impedance converter 35 using the coaxial cable through the small openings.

The probe mounting portion 14 has a structure that a vacuum sealing is achieved by using an O-ring, grease, or the like as is the case with ordinary viewing ports.

In this case, the probe electrode 32 contacts with the coaxial cable by way of a spring pin, and a contact between the ITO shield 34 and the probe mounting portion 14 is achieved in the same manner.

As described above, since whole parts of a viewing port portion of the detection port type probe 30 are formed from the transparent materials, the detection port type probe 30 has an innovative and great advantage of functioning as a viewing port of the process chamber of the plasma processing apparatus.

Hereinafter, a theory of monitoring a plasma state by the detection port type probe will be described.

Reference is made to Fig. 2 again.

After introducing a reaction gas from the gas inlet 12 into the process chamber 11, an RF power is applied between the upper electrode 17 and the lower electrode 15 under a constant pressure to generate plasma 21 between the electrodes, and ions and electrons in the plasma diffuse into a wall of the process chamber 11 due to a density gradient of the plasma.

Since a current density of the diffused ions and electrons depends on the density of the plasma itself, when an insulator is disposed at a part of the process chamber 11, a potential called wall potential is induced on the insulator, i.e. on the glass plate 31 in this invention, so as to balance with a plasma potential of the plasma depending on a flux of ions or electrons diffused from the plasma and passing though a sheath formed near the surface of the insulator.

The wall potential induced on the surface of the glass plate 31 is lower than the plasma potential by a sheath potential and exhibits potential changes in synchronization with an excitation frequency of plasma in the case of radio frequency discharge while exhibiting a constant potential in DC discharge.

However, in the case where the plasma 21 fluctuates and oscillates due to a factor such as a fluctuation in power source and a fluctuation in gas pressure, the state of the plasma 21 changes to that of plasma 22 so that the ion flux or the electron flux diffusing into the wall of the process chamber 11 changes delicately depending on the state change, thereby delicately changing the wall potential to be induced on the glass plate 31 which is the dielectric disposed in the process chamber 11.

Therefore, the wall potential waveform is not constant but fluctuates in synchronization with the plasma fluctuation in the DC discharge, while the potential waveform in the RF discharge synchronizes with the plasma excitation frequency to change a waveform distortion or a peak value.

In the case of occurrence of a sudden change such as anomalous discharge, the plasma changes rapidly to cause electrons having smaller mass to react delicately, so that the electron flux is sharply reduced to change the wall potential delicately and sharply to the plus side. In turn, the wall potential is changed to the minus side when the electron flux is increased.

Therefore, when the wall potential changes, a potential change responsive to the plasma change is induced on the probe electrode 32 disposed on the sideface which is not facing to the plasma of the glass plate 31 disposed in the process chamber 11 by an electrostatic induction.

By measuring the induced potential and processing potential data thereof, it is possible to detect changes in plasma state such as the peak value, the distortion state, and the like of the wall potential, and, by using the plasma state changes as an index, it is possible to efficiently and conveniently perform monitoring and determination of stability, reproducibility, changes, and the like of the plasma.

Note that, since the wall potential induced on the surface of the glass plate 31 of the detection port type probe 30 depends on the impedance of the sheath formed around the glass plate 31 and the impedance of the probe itself, the impedance of the probe electrode 32 with respect to the radio frequency component, not only the excitation frequency, must be large enough for the probe electrode 32 to oscillate perfectly parallelly with the plasma potential.

That is to say, it is necessary to keep the sheath impedance small and the impedance of the detection port type probe itself large.

A surface area of the glass plate 31 has only to be increased for the purpose of reducing the sheath impedance, and an area of a portion facing to the plasmas 21 and 22 of the glass plate 31 of the detection port type probe 30 of this invention must be sufficiently increased.

It is not necessary to accurately detect the impedance of the probe electrode 32 constituted of ITO, and, since the probe voltage reaches to the maximum value when the impedance is at infinity, the impedance has only to be adjusted in such a manner that the wall potential of the probe reaches to its maximum value.

Next, voltage waveforms measured by using the detection port type probe of this invention will be described with reference to Figs. 4 to 6.

Reference is made to Fig. 4(a).

Shown in Fig. 4(a) is a voltage waveform output from the detection port type probe 30 when plasma is generated stably with a power supply from the radio frequency power source 18 to the process chamber 11.

Referring to Fig. 4(a), time (second) and a voltage are indicated by the horizontal axis and the vertical axis, and it is revealed that a stable voltage waveform is repeated with a cycle of 73 nanoseconds (73 ns = 7.3 $\times$ 10$^{-8}$ s) in accordance with the frequency of 13.56 MHz, thereby making it possible to measure an oscillation waveform and an amplitude of the plasma.

Reference is made to Fig. 4(b).

Shown in Fig. 4(b) is a voltage waveform observed in the case of unstable plasma, and, as shown in Fig. 4(b), it is determined that the voltage waveform has a distortion and that a peak value fluctuates cyclically.

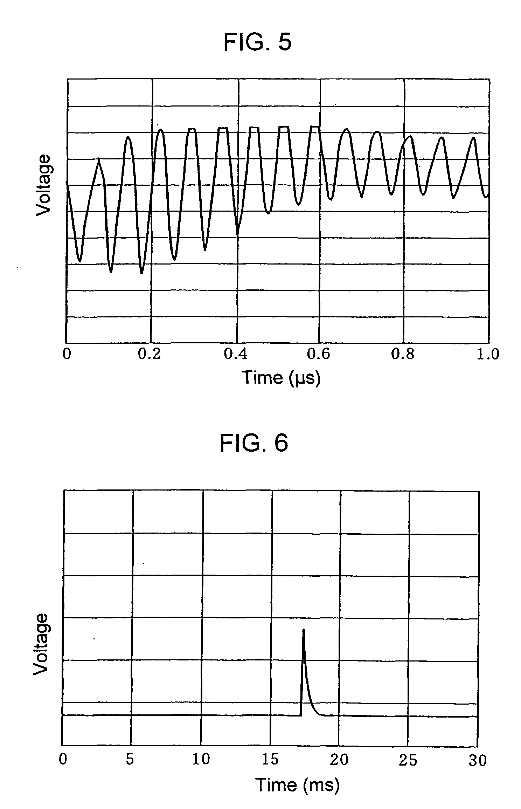

Reference is made to Fig. 5.

Fig. 5 is an illustration of a waveform detected by the detection port type probe in the case where an input power fluctuates in RF discharge, and it is observed that the detected waveform gradually changes with the fluctuation in input power.

In this case, it is confirmed that a peak value in the detected waveform is in proportion to the RF input power. The waveform detected by the detection port type probe changes with a cycle of the frequency of the radio frequency power source 19, and the waveform distortion state, the peak value, and the like reflect plasma characteristics.

Reference is made to Fig. 6.

Fig. 6 is an illustration of a waveform detected by the detection port type probe when the RF power source is immediately disconnected after an apparatus malfunction in the RF discharge, wherein the detected waveform reacts to fluctuate on the plus side because the wall potential fluctuates to the minus side due to a rapid diffusion of electrons having smaller mass caused by the immediate disconnection of the RF power source.

Thus, the detection port type probe 30 of this invention catches delicate changes of the ion flux or the electron flux diffused in response to the changes in plasma state, thereby detecting the changes in plasma state reliably, efficiently, and sensitively.

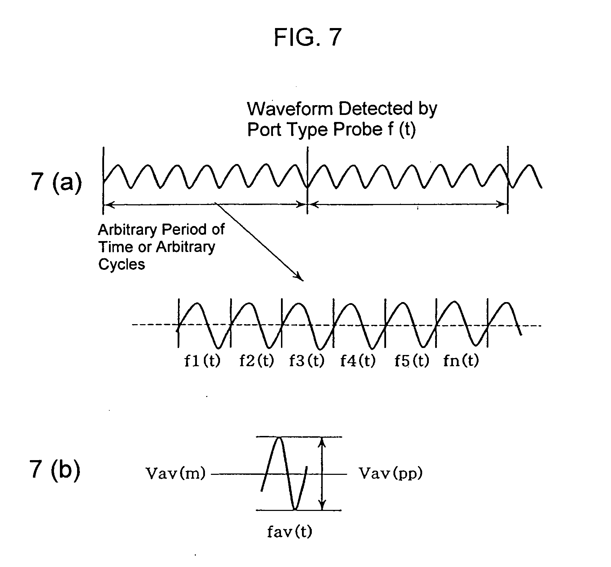

Next, a method of processing a waveform detected by the detection port type probe in the first embodiment of this invention will be described with reference to Fig. 7.

Reference is made to Fig. 7(a).

As shown in Fig. 7(a), an average value $V_{av}$(m), an average amplitude $V_{av}$(pp), and an averaged waveform $f_{av}(t)$ are obtained from waveforms $f_i(t)$ detected during cycles for an arbitrary period of time or in an arbitrary number (n) of cycles, the waveforms $f_i(t)$ being included among voltage waveforms f(t) detected by the detection port type probe 30.

In this case, the averaged waveform $f_{av}(t)$ is obtained from

$$f_{av}(t) = \Sigma f_i(t)/n.$$

Reference is made to Fig. 7(b).

Next, based on the averaged waveform $f_{av}(t)$, the average value $V_{av}$(m) and the amplitude $V_{av}$(pp) are obtained.

In order to use, as an index, ratios of distortions of the average value $V_{av}$(m), the amplitude $V_{av}$(pp), and the average waveform $f_{av}(t)$ to those obtained in a stable plasma state, the values obtained under predetermined conditions of a plasma processing apparatus for processing a basic waveform and using the detection port type probe when the plasma is in a stable state are obtained as detected waveform data to be used as basic waveform data.

A waveform $f_{av0}(t)$ averaged as a waveform of one cycle, $V_{av0}(pp)$, and $V_{av0}(m)$ are then obtained by setting the cycles to an arbitrary period of time or an arbitrary number of the basic waveforms with respect to the basic waveform data.

Further, since the above values change in accordance with input power for generating plasma, a coefficient for the input power is obtained to be stored as an initial setting value.

Here, when the waveform to be detected is $f(t)$, the distortion ratio $\alpha$ as the index for indicating a degree of a distortion of a probe waveform undergoing the plasma treatment with respect to the basic waveform can be expressed as

$$\alpha = f_{av}(t)/f_{av0}(t),$$

and a proportion of a higher harmonic wave component and the degree of distortion of the waveform are detected by the above expression.

Likewise, $V_{av}(m)$ and $V_{av0}(pp)$ can be defined as follows, wherein $V_{av0}(m)$ and $V_{av0}(pp)$ are reference values and m and p are coefficients:

$$m = V_{av}(m)/V_{av0}(m);$$

and

$$P = V_{av}(pp)/V_{av0}(pp).$$

By the use of the coefficients $\alpha$, m, and p, it is possible to detect a fluctuation in size and a state of oscillation of the waveform detected by the probe.

More specifically, the coefficients $\alpha$, m, and p are set for every input power in advance, and the average waveform $f_{av}(t)$ of the waveforms detected by the probe during the arbitrary period of time or the arbitrary cycles is obtained to be compared with the reference waveform $f_{av}(0)$. It is then judged whether the thus-obtained coefficient $\alpha'$ is larger or smaller than the value set in the data processing unit, so that a warning is sent to the plasma apparatus in the case where $\alpha'$ is larger or smaller than the predetermined value.

For instance, in the case where the distortion ratio $\alpha'$ or $V_{av}(pp)$ is the predetermined value and $V_{av}(m)$ is not the predetermined value, the oscillation of plasma might be attributable to problems other than the plasma power input error, such as errors relating to a gas flow ratio and a degree of vacuum; therefore, a warning indicating the unstable state of plasma is transmitted.

Also, when the $V_{av}(pp)$ simply deviates from the predetermined value, such deviation is attributable to a mismatching between impedances of the plasma 21 and the radio frequency power source 19 or to an error in input power settings of the radio frequency power source 19. In the case where $V_{av}(pp)$ is smaller than the predetermined value, the deviation is attributable to the mismatching with plasma; therefore, a warning is transmitted and a control signal is output to the plasma power source so that matching with the plasma is achieved.

In turn, in the case where the $V_{av}(pp)$ is larger than the predetermined value, the deviation is attributable to the error in input power setting of the radio frequency power source 19; therefore, a warning of a setting error is transmitted.

Since the detection port type probe of the first embodiment of this invention operates without any difficulty even when an insulating layer is deposited due to a long term plasma treatment insofar as the deposited insulating layer becomes extremely thick, applicability thereof to the plasma processing apparatuses in the production sites is excellent from the standpoint of cost and installation space.

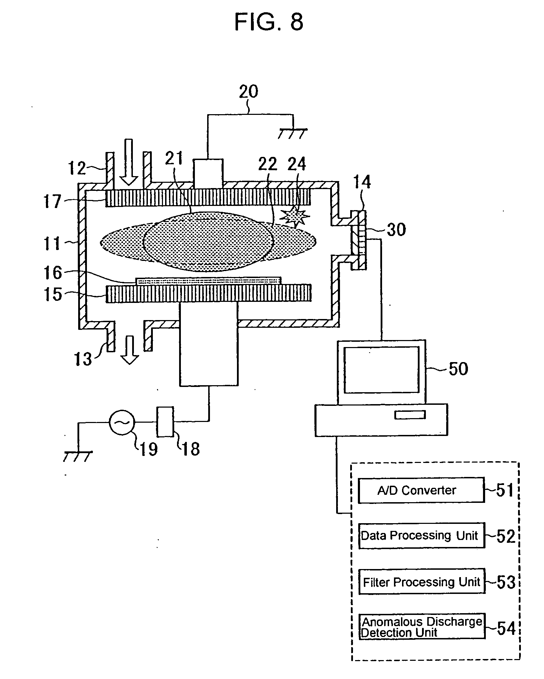

Next, with reference to Figs. 8 to 10, a plasma processing apparatus according to a second embodiment of this invention, which is provided with the above-described detection port type probe and detects a fluctuation in plasma, anomalous discharge, and so forth, will be described.

Reference is made to Fig. 8.

Fig. 8 is a schematic block diagram showing the plasma processing apparatus with an anomalous discharge monitoring device according to the second embodiment of this invention. A basic constitution of the plasma processing apparatus is the same as that of the first embodiment except for using a plasma monitoring device 50 in place of the digital oscilloscope 40 in the detection system, and descriptions for the same parts are omitted.

The plasma monitoring device 50 is constituted of a detection port type probe 30, an A/D converter 51, a data processing unit 52, a filter processing unit 53, and an anomalous discharge detection unit 54, and so forth.

By the use of the data processing unit 52, an average waveform $f_{av}(t)$, an average voltage $V_{av}(m)$, an average amplitude $V_{av}(pp)$, and coefficients $\alpha$, m, and p, which are described in the first embodiment, are obtained based on detected waveforms.

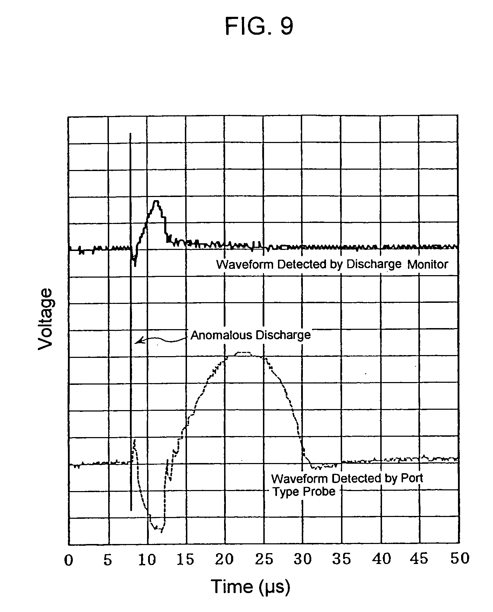

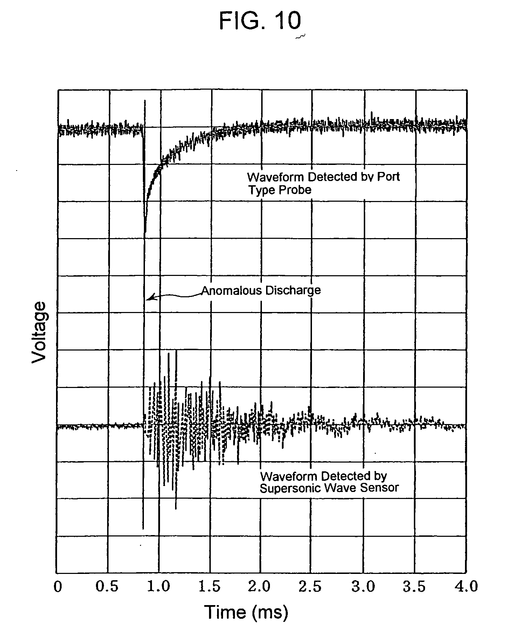

A normal process monitoring is the same as that described in the first embodiment, and anomalous discharge detection will hereinafter be described with reference to Figs. 9 and 10.

Reference is made to Fig. 9.

Fig. 9 is an illustration of a waveform detected by the detection port type probe in the case of anomalous discharge in DC discharge in the second embodiment, wherein a plasma generating power source voltage and a waveform detected by an discharge monitor for detecting anomalous discharge by measuring a fluctuation in current are also shown.

The detected waveform of the discharge monitor shown in the upper side is increased rapidly in response to the generation of anomalous discharge.

In turn, the detected waveform of the detection port type probe shown in the lower side fluctuates on the plus side instantaneously with a sharp rising and then converges as fluctuating from the minus side to the plus side. This indicates that, because of the instantaneous suspension is caused upon occurrence of the anomalous discharge to sharply increase the diffusing electron flux, the wall potential fluctuated to the minus side instantaneously and in reverse to the fluctuation at the time of the power source disconnection shown in Fig. 6 and then converged with the comparatively gradual change owing to the power source control.

It will be understood from the detected waveform of the detection port type probe that the waveform is quicker in rising than that of the discharge monitor and responses delicately and sensitively.

Reference is made to Fig. 10.

Fig. 10 is an illustration of a waveform detected by the detection port type probe in the case of anomalous discharge in RF discharge in the second embodiment, wherein a waveform detected by a supersonic wave sensor for detecting a supersonic wave at the time of occurrence of anomalous discharge in RF plasma is also shown.

In addition, the present inventor has proposed a method of specifying a discharge occurrence position by detecting an AE (Acoustic Emission) generated by anomalous discharge with the use of an AE sensor attached to an outer wall of a plasma processing apparatus by taking advantage of the fact that the supersonic wave (AE) is generated when anomalous discharge 24 occurs during plasma processing to diffuse into the outer wall of the plasma processing device (see JP-A-2000-89840, when necessary).

The detected waveform of the detection port type probe shown in the upper side responds delicately to the anomalous discharge 24 to rapidly fluctuate on the minus side as is the case with the anomalous discharge occurred in the DC plasma shown in Fig. 9 and to cause the wall potential to fluctuate on the minus side, thereby revealing that a diffused electron amount is increased to bring the plasma into an instantaneous suspension state.

Note that an RF component has been eliminated from the detected waveform of the detection port type probe.

In turn, the detected waveform of the supersonic wave sensor shown in the lower side reveals that the supersonic wave detection relating to the anomalous discharge is performed after the change in detected waveform of the detection port type probe of the upper side due to a relationship between a position of the occurrence of the anomalous discharge and a diffusion speed of the supersonic wave diffusing into the outer wall of the process chamber 11.

Next, a method of detecting anomalous discharge will be briefly described.

The detected waveform of the detection port type probe 30 is input via the A/D converter 51, and an RF component at 13.56 MHz of waveform data thereof is eliminated by using a low-pass filter in the filter processing unit 53, followed by a detection of an anomalous discharge signal in the anomalous discharge detecting unit 54.

Then, the detected waveform f(t) is subjected to differentiation so as to obtain a fluctuation amount of the waveform from the detected signal. When the value obtained by the differentiation is represented by $\beta$,

$$\beta = df(t)/dt$$

holds.

It is possible to detect a fluctuation state of the waveform by monitoring $\beta$.

As shown in Figs. 10 and 6, in the case of the anomalous discharge or the instantaneous suspension of power supply, the wall potential changes sharply to change a value of $\beta$ toward the plus side or the minus side in the anomalous discharge detecting unit 54.

Accordingly, an anomalous state is detected when a value of f(t) exceeds a certain threshold value to cause the value of $\beta$ to be larger than a predetermined value, and it is judged that the anomalous discharge has occurred when the value $\beta$ is on the minus side, whereby a warning is sent to the plasma processing apparatus.

Further, since the changes in current supply are relevant to the size of anomalous discharge, it is possible to estimate the size of the anomalous discharge from a peak value V(pp) of the waveform.

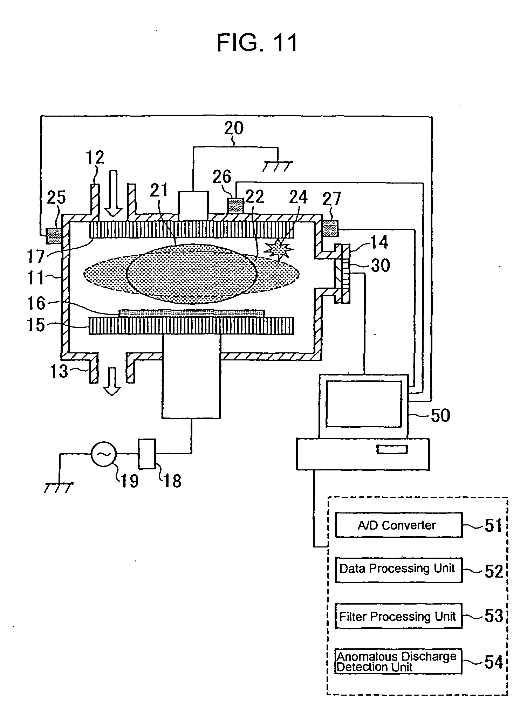

Hereinafter, a third embodiment of this invention which uses a unit for determining a position of anomalous discharge will be described with reference to Fig. 11.

Reference is made to Fig. 11.

Fig. 11 is a schematic block diagram showing a plasma processing apparatus with an anomalous discharge monitoring device according to the third embodiment of this invention. A basic apparatus constitution is the same as that of the plasma processing apparatus of the second embodiment shown in Fig. 8.

In the third embodiment, three or more AE sensors 25, 26, and 27 for specifying a position at which anomalous discharge has occurred are attached to an outer wall of a process chamber 11 (see, JP-A-2001-370610, when necessary).

In this case, three AE sensors are shown.

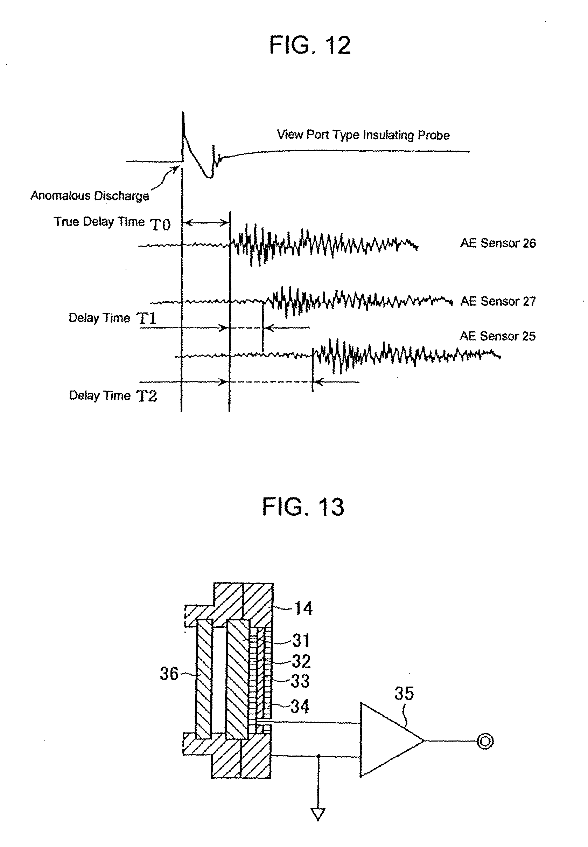

Reference is made to Fig. 12.

Fig. 12 is an illustration of a method for detecting anomalous discharge in the third embodiment of this invention. It is judged whether or not the anomalous discharge has occurred from a waveform shown in the upper side, which is detected by the detection port type probe 30, by employing the above-described method, and, when it is judged that the anomalous discharge 24 has occurred, operation of the AE sensors 25 to 27 for determining the position of occurrence of the anomalous discharge 24 starts.

Next, delay times $T_0$, $T_1$, and $T_2$ due to differences in distance between the occurrence position of the anomalous discharge 24 and earthing positions of the AE sensors 25 to 27 are obtained from three waveforms detected by the three AE sensors 25 to 27, and then the occurrence position of the anomalous discharge 24 is specified by a theory similar to that for specifying the epicenter of an earthquake from the delay times $T_0$, $T_1$, and $T_2$.

Since the judgment of the anomalous state is performed by the use of the detected waveform of the detection port type probe 30, an erroneous judgment of judging a mechanical vibration detected by the AE sensors as the anomalous discharge is prevented.

Further, since the position specifying operation by the AE sensors is performed after confirming the occurrence of anomalous discharge based on the detected waveform of the detection port type probe 30, wasteful actuation of the AE sensors is prevented.

Hereinafter, a detection port type probe of a fourth embodiment of this invention will be described with reference to Fig. 13.

Reference is made to Fig. 13.

Fig. 13 is a schematic block diagram showing the detection port type probe of the fourth embodiment of this invention, wherein the detection port type probe has a basic constitution which is similar to that of the detection port type probe 30 shown in Fig. 3 and is constituted of a glass plate 31 made from the optically transparent kovar glass or the like which is used for ordinary viewing ports, a probe electrode 32 disposed on an outer surface of the glass plate 31 with respect to the process chamber and made from ITO or the like, a transparent insulating film 33 insulating coating a surface of the probe electrode 32 and made from polyester or the like, an ITO shield 34 disposed on the transparent insulating film 33 so as to electromagnetically shield the probe electrode 32, and an impedance converter 35.

In the fourth embodiment, an optically transparent deposition-free glass plate 36 is disposed at a position which is closer to a plasma generation region than the glass plate 31 is, and it is possible to prevent occurrence of contamination on a surface of the glass plate 31 constituting the detection port type probe owing to the deposition-free glass plate 36.

In this case, too, the probe electrode 32 has no periphery so as to prevent an occurrence of electrical short with a probe mounting portion 14, and a small opening is formed on each of the ITO shield 34 and the transparent insulating film 33 so that the probe electrode 32 is connected to the impedance converter 35 through the small openings by way of a coaxial cable.

Further, the probe mounting portion 14 has a structure that a vacuum sealing is achieved by using an O-ring, grease, or the like as is the case of ordinary viewing ports.

In this case, too, since a viewing port portion of the detection port type probe and the deposition-free glass plate 36 are formed from the transparent materials, the detection port type probe has the innovative and great advantage of functioning also as a viewing port of the process chamber of a plasma processing apparatus.

Since the deposition-free glass plate 36 has only to be replaced in the case of contamination by reaction products of plasma processing, a necessity for replacement and cleaning of the glass plate 31 of the detection port type probe is eliminated.

Note that detection sensitivity is slightly degraded by the provision of the deposition-free glass plate 36.

The foregoing is the description of the embodiments of this invention, and the constitutions and conditions described in the embodiments do not limit the invention and are subject to various modifications.

For instance, though the parallel flat plate electrode type plasma processing apparatus is used by way of example for describing the plasma processing apparatus in the above embodiments, the constitution of the plasma processing apparatus is not limited to that of the parallel flat plate electrode type plasma processing apparatus, and the invention is applicable to plasma processing apparatuses of various constitutions.

Also, though the detection port type probe is disposed at one position of the outer wall of the process chamber in the above embodiments, the detection port type probe may be disposed at a plurality of positions on the process chamber outer wall.

Though the description is made on condition that the mounting portion of the detection port type probe is secured in the process chamber in the above embodiments, the detection port type probe may be attached to an existing plasma processing apparatus.

That is, in the case where the existing plasma processing apparatus has a viewing port, it is possible to simply form the detection port type probe by attaching an optically transparent electroconductive sheet such as an ITO sheet as the electrode on the side facing to the air of the glass of the viewing port.

Further, though the device which is capable of measuring the radio frequency voltage, such as the digital oscilloscope having the input impedance of 50 $\Omega$, is used for the measurement of probe potential, the probe potential measurement device is not limited to the digital oscilloscope, and any device such as a sampling oscilloscope and a frequency analyzer may be used insofar as it is capable of measuring the radio frequency voltage.

Though the dielectric used for inducing the wall potential in the detection port type probe is the substrate-like glass plate in the above embodiments, the dielectric is not limited to the substrate-like glass plate.

Though the glass plate is used as a material for inducing the wall potential in the detection port type probe in the above embodiments, the material for inducing the wall potential is not limited thereto, and a dielectric substrate such as a sapphire substrate may be used as the dielectric substrate insofar as it is dielectric.

Though the whole part of the detection port type probe is formed from the transparent materials so that the detection port type probe functions also as the viewing port, it is unnecessary to form the whole part from the transparent materials. For example, the probe electrode may be formed from Al or Au.

In this case, the function of viewing port is achieved by using a small disk-like electrode or a circular electrode as the probe electrode.

The function of the viewing port is not always necessary, and at least a part of the detection port type probe may be formed from a non-transparent material in the case where the viewing port function is unnecessary.

The probe electrode of the detection port type probe may not necessarily have the disk-like shape, and it is needless to say that a glass plate to which a wire electrode is attached functions as a probe.

Industrial Applicability

As described in the foregoing, by the use of the detection port type probe and the plasma monitoring device of this invention, it is possible to determine changes in plasma state through measurements of the average wall potential and the potential oscillation waveform as well as to conveniently detect an anomalous state or the like of anomalous discharge. Particularly, since the detection port type probe can be used as a viewing port, it is possible to automatically detect a condition of a plasma processing apparatus. Therefore, the detection port type probe is suitably used for plasma processing apparatuses capable of preventing defective products by automatically stopping and controlling plasma.

**Claims**

1. A detection port type probe **characterized by** comprising at least an electroconductive supporting member having an opening formed on at least a part of a surface thereof facing to plasma and a dielectric member having a probe electrode formed on one side thereof positioned at the opening of the electroconductive supporting member.

2. The detection port type probe according to claim 1, **characterized by** connecting an impedance matching unit to the probe electrode.

3. The detection port type probe according to claim 1, **characterized in that** the dialectic member is made from an optically transparent glass.

4. The detection port type probe according to claim 3, **characterized in that** the probe electrode is made from an optically transparent electroconductive substance.

5. The detection port type probe according to claim 1, **characterized in that** the opening formed on the electroconductive supporting member has a function of a viewing port.

6. A plasma monitoring device using the detection port type probe defined in claim 1, **characterized in that** a voltage waveform measuring unit for measuring a voltage waveform is disposed at an output end of the detection port type probe.

7. The plasma monitoring device according to claim 6, **characterized by** comprising a process monitoring mechanism for detecting a stability of plasma by detecting a degree of nonuniformity among cyclical waveform changes of the voltage waveform detected by the voltage waveform measuring unit.

8. The plasma monitoring device according to claim 6, **characterized by** comprising an anomalous discharge monitoring mechanism for detecting anomalous discharge of plasma from the changes in voltage waveform detected by the voltage waveform measuring unit.

9. A plasma processing apparatus **characterized by** comprising the plasma monitoring device defined in claim 6.

10. The plasma processing apparatus according to claim 9, **characterized in that** the electroconductive supporting member provided with the opening is a flange constituting a viewing port of a reaction vessel, and that the dielectric member is a transparent glass plate for sealing the flange.

# FIG. 1

# FIG. 2

## FIG. 3

## FIG. 4

4 (a)

4 (b)

## FIG. 5

Time (μs)

## FIG. 6

Time (ms)

## FIG. 7

Waveform Detected by
Port Type Probe f (t)

7 (a)

Arbitrary Period of
Time or Arbitrary
Cycles

f1 (t)    f2 (t)    f3 (t)    f4 (t)    f5 (t)    fn (t)

7 (b)

Vav(m) ———————— Vav(pp)

fav (t)

## FIG. 8

A/D Converter ~51

Data Processing Unit ~52

Filter Processing Unit ~53

Anomalous Discharge Detection Unit ~54

FIG. 9

FIG. 10

Waveform Detected by Port Type Probe

Anomalous Discharge

Waveform Detected by Supersonic Wave Sensor

Voltage

Time (ms)

0    0.5    1.0    1.5    2.0    2.5    3.0    3.5    4.0

# FIG. 11

A/D Converter — 51

Data Processing Unit — 52

Filter Processing Unit — 53

Anomalous Discharge Detection Unit — 54

## FIG. 12

View Port Type Insulating Probe

Anomalous Discharge

True Delay Time T0

AE Sensor 26

AE Sensor 27

Delay Time T1

AE Sensor 25

Delay Time T2

## FIG. 13

14
31
32
33
34
36
35

## INTERNATIONAL SEARCH REPORT

| International application No. |
| --- |
| PCT/JP03/04016 |

**A. CLASSIFICATION OF SUBJECT MATTER**
Int.Cl⁷ H01L21/205

According to International Patent Classification (IPC) or to both national classification and IPC

**B. FIELDS SEARCHED**

Minimum documentation searched (classification system followed by classification symbols)
Int.Cl⁷ H01L21/205

Documentation searched other than minimum documentation to the extent that such documents are included in the fields searched

| | | | |
| --- | --- | --- | --- |
| Jitsuyo Shinan Koho | 1926–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 3-185825 A  (Hitachi, Ltd.),<br>13 August, 1991 (13.08.91),<br>Full text<br>(Family: none) | 1–10 |
| A | JP 3-64897 A  (Mitsui Toatsu Chemicals, Inc.),<br>20 March, 1991 (20.03.91),<br>Full text<br>(Family: none) | 1–10 |

☐ Further documents are listed in the continuation of Box C.  ☐ See patent family annex.

| | | |
| --- | --- | --- |
| * | Special categories of cited documents: | |
| "A" | document defining the general state of the art which is not considered to be of particular relevance | |
| "E" | earlier document but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 01 July, 2003 (01.07.03) | 22 July, 2003 (22.07.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)